# EUROPEAN PATENT SPECIFICATION

(11) **EP 0 469 588 B1**
(45) Date of publication and mention of the grant of the patent: **03.12.1997**
(21) Application number: 91112893.2
(22) Date of filing: 31.07.1991
(51) Int. Cl.: G11C 5/14, G11C 11/407, H03K 17/22

(54) **Power up reset pulse generator**
Einschalt-Rücksetzimpulsgenerator
Générateur d'impulsion d'initialisation lors d'une mise sous tension

(30) Priority: 31.07.1990 US 561536
(43) Date of publication of application: 05.02.1992
(73) Proprietor: TEXAS INSTRUMENTS INCORPORATED, Dallas Texas 75265 (US)
(72) Inventor: Tsay, Ching-Yuh, Richardson, Texas 75082 (US); Redwine, Donald J., Houston, Texas 77031 (US)
(74) Representative: Leiser, Gottfried, Dipl.-Ing.

(56) References cited:
- EP-A- 0 354 784
- RESEARCH DISCLOSURE no. 277, May 1987, NEW YORK;USA page 317 'CMOS ON-CHIP VDD LOCK-OUT PULSE'

## Description

This invention relates to integrated circuits, and in particular to integrated circuit devices formed in a semiconductor substrate, for example memory devices such as dynamic random access memories. More particularly the invention relates to an integrated circuit as defined in the precharacterizing part of claim 1.

The development of very large scale integrated circuit (VLSI) semiconductor devices of the Dynamic Random Access Memory (DRAM) type is well known. Over the years, the industry has steadily progressed from DRAMS of the 16K type (as shown in the U.S. Pat. 4,055,444 issued to Rao) to DRAMS of the 1MB type (as shown in U.S. Pat. 4,658,377 issued to McElroy), and progressed to DRAMS of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB DRAM type, designers are faced with numerous challenges.

One cause for concern, for example, is power consumption and another is device behavior at power up.

In a very large scale integrated (VLSI), a power up pulse is usually needed for resetting internal logic to ensure the integrated circuit powers up at a known state. This pulse has to be reliably generated regardless of how fast or slowly the external supply ramps up and down, and regardless of how often external supply powers up and down. In the application of dynamic random access memory (DRAM) where the substrate is biased, the detection circuit also needs to generate power up pulse under different substrate potentials.

Because of power consumption considerations, logic circuits are also frequently used in controlling the internal voltage regulator. If the control logic is powered by internal voltage, there is an unresolved loop between the control signals and the supply voltage during power up phase. It is essential to make sure that the interlock be broken to ensure the establishment of internal voltage for proper circuit operations. In an internally regulated VLSI circuit, a power up signal is also needed to ensure the internal voltage regulator starts with correct initial state, e.g., in DRAM application, internal voltages need to be stable for precharge and ready for active cycle operation. Such a signal can also be used, for example, to speed up the ramping of internal voltage and also to speed up the establishment of bit line reference potential. The voltage regulator should also generate a signal that inhibits other circuits from operation until internal levels are well established.

Research Disclosure, no. 277, May 1987, p. 317 describes an integrated reset pulse generating circuit to generate a power up reset pulse. This reset pulse generating circuit comprises a CMOS-inverter whose input is coupled via input coupling means to an external voltage. In this circuit no on chip voltage generator for receiving the external voltage and producing an internal voltage is provided.

According to the present invention there is provided an integrated circuit to generate a power up reset pulse for a semiconductor device comprising a CMOS inverter biased between an external voltage and ground, having its input coupled by an n-channel pull down transistor to ground; and a p-channel pull up transistor biased by the external voltage, connected to the input of the CMOS inverter, and having its gate connected to the output of the CMOS inverter, characterized in that said semiconductor device has an on chip voltage generator that receives said external voltage and produces an internal voltage and in that the gate of the pull down transistor is connected to said internal voltage.

Advantageously, the circuit further comprises a capacitive means for coupling the input of the CMOS inverter to the external voltage. The capacitive means may be a p-channel transistor having its gate connected to the input of the CMOS inverter and its source and drain connected to the external voltage. A capacitor may have one terminal connected to the output of the CMOS inverter and the other terminal connected to ground.

Advantageously, the circuit further comprises reverse bias leakage diode coupling means for coupling the input of the CMOS inverter to the external voltage. The reverse bias leakage diode coupling means may be a P-channel transistor having its drain connected to the input of the CMOS inverter, and having its gate, source, and substrate connected to the external voltage.

The circuit may further comprise a buffer biased by the external voltage having its input connected to the output of the CMOS inverter.

As part of this application, an exemplary circuit to generate a power up reset pulse for a semiconductor device, such as a dynamic random access memory (DRAM) that may utilize an on chip voltage generator is disclosed. The circuit, after its output passes through an inverter, generates a positive going pulse when the external power supply ramps up. The pulse disappears when the voltage level within the device reaches a predetermined value of the external supply voltage. The circuit includes a CMOS inverter that is biased between the external voltage and ground and has its input coupled to the internally regulated voltage. A pull down transistor controlled by internally regulated voltage couples the input of the CMOS inverter to ground. A pull up transistor that is biased by the external voltage and whose gate is connected to the output of the CMOS inverter, is connected to the input of the CMOS inverter. Other elements may be added to enhance the circuits performance. The trip point of the circuit with respect to the externally supplied voltage may be adjusted by varying the relative sizes of the pull down transistor and the pull up transistor.

The objects, advantages and features of the invention will become apparent to those of ordinary skill in the art, having reference to the following description of embodiments of the invention which together with the accompanying drawings are provided by way only of example.

In the drawings:-
FIG. 1 is a block system level drawing illustrating a 16MB Dynamic Random Access Memory chip incorporating an embodiment of the invention,
FIG. 2 is a top view drawing illustrating the pin designations of the packaged memory chip,
FIG. 3 is a three-dimensional view of the packaged memory chip wherein the encapsulating material is rendered transparent,
FIG. 4 is an assembly view if FIG. 3,
FIG. 5 is a cross-sectional view of FIG. 3,
FIG. 6 is a top view drawing illustrating the bond pad designations of the memory chip,
FIG. 7 is a top view drawing illustrating a portion of the memory array,
FIG. 8 is a cross-sectional view of a portion of the memory array,
FIG. 9 is a side view of the cross-sectional view of FIG. 8,
FIG. 10 illustrates a circuit VRCTLS incorporating the invention.

An exemplary embodiment of the invention and a memory chip including the invention will now be described.

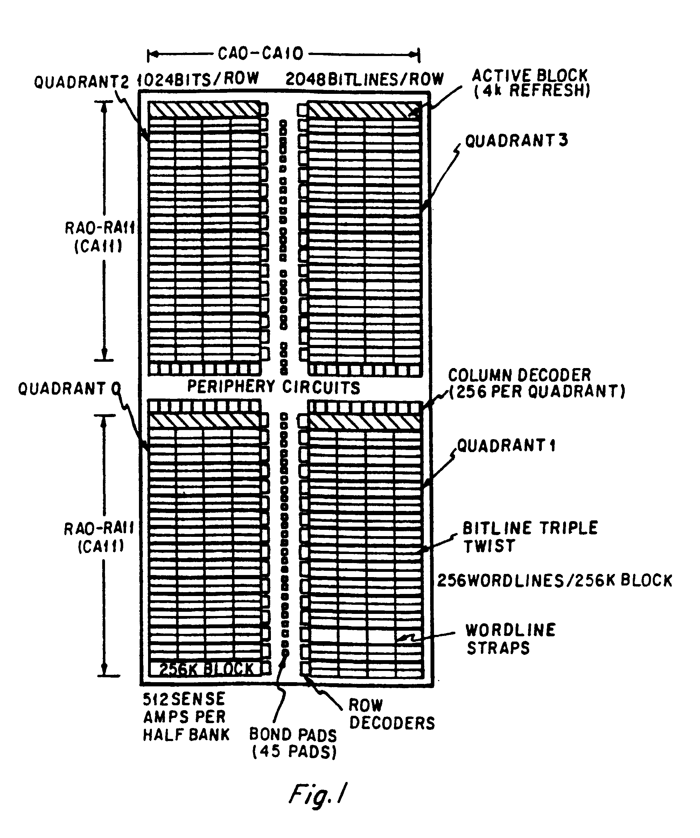

Fig. 1 illustrates a 16 Megabit Dynamic Random Access Memory Chip referred to as a 16MB DRAM. The chip size is about 325 X 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

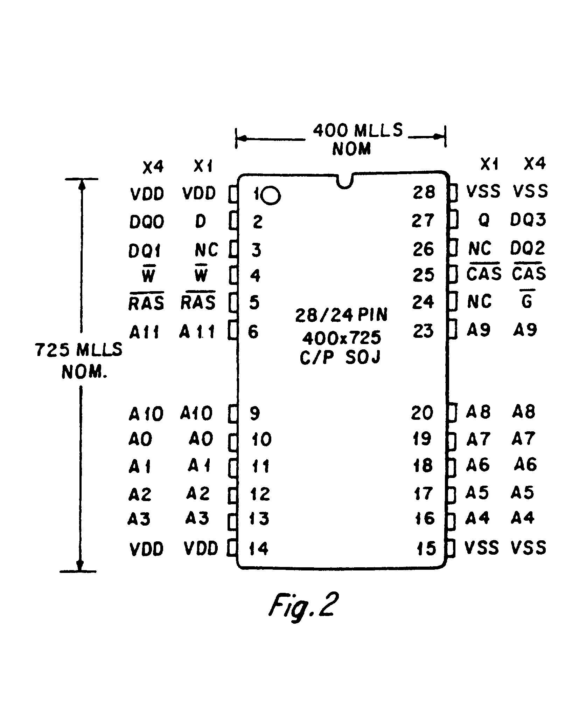

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

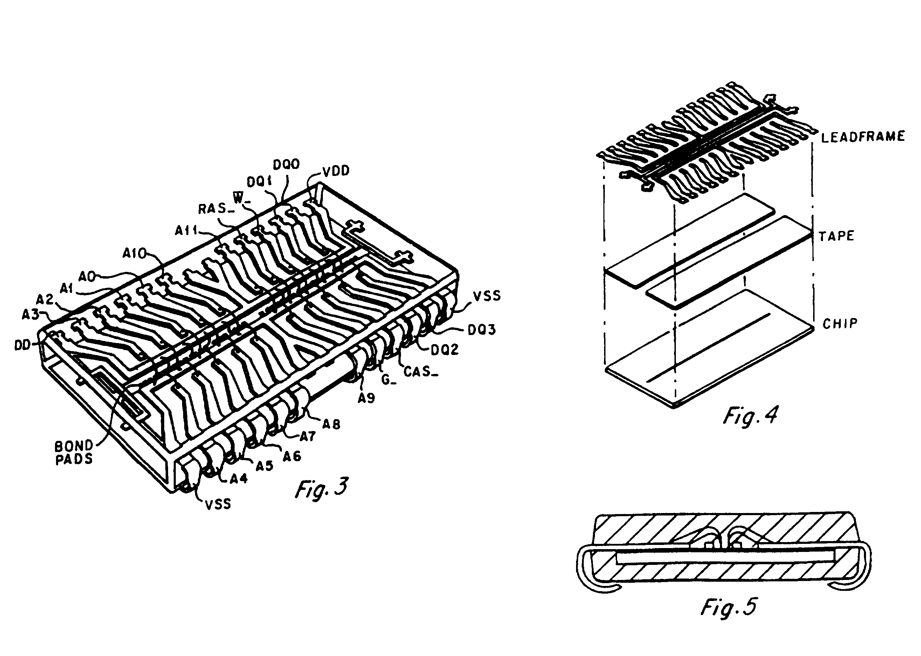

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and

FIG. 5 is a cross-section view of the packaged device.

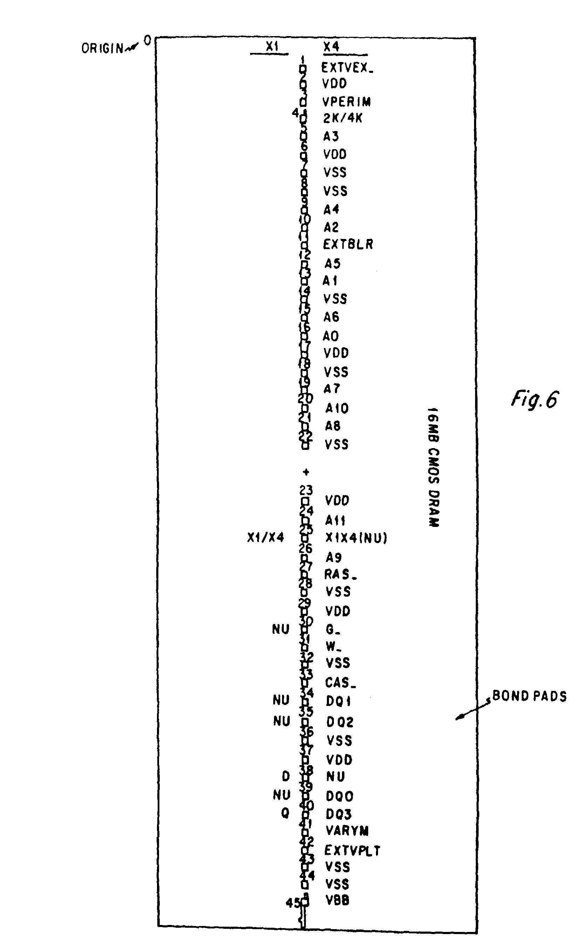

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and V_{SS} for a X1 device and omitting the bond wire for a X4 device. The resulting pin outs for the ten options may be seen in FIG. 2. The bond wire may be run between pad 25 and the V_{SS} bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to V_{SS} for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

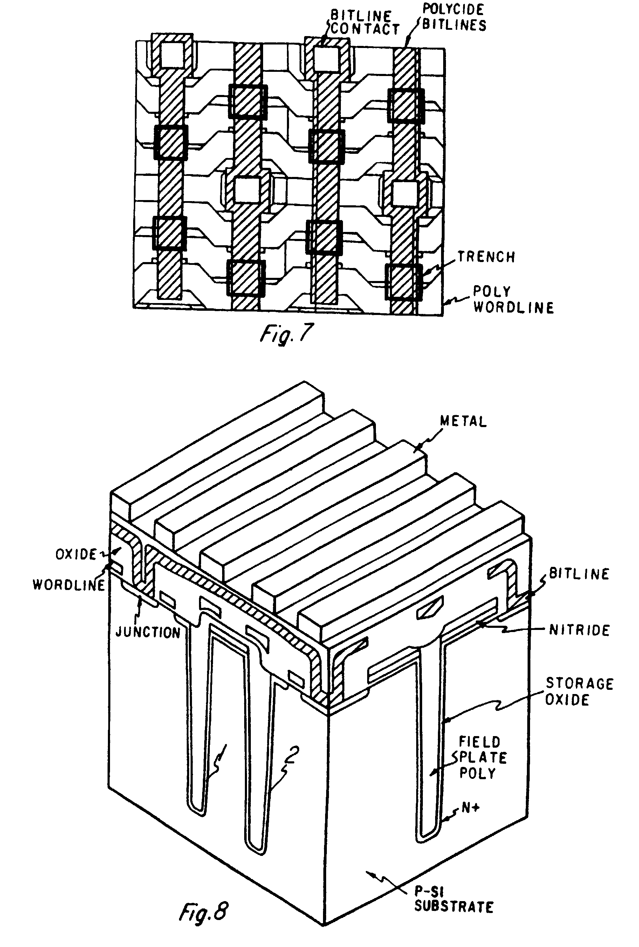

FIG. 7 is a top view of the capacitor cell layout. The bit lines are poly-3 (TiSi₂) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

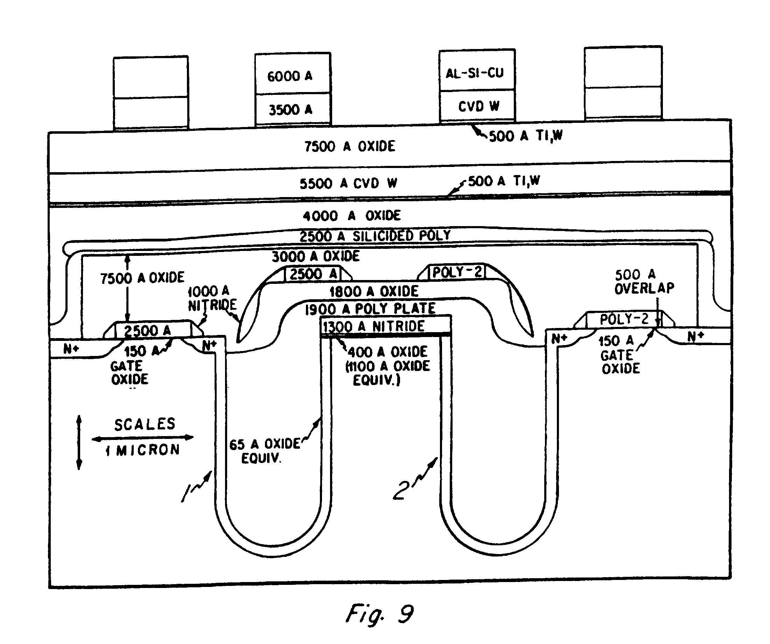

In FIG. 7, the dimensions include a 1.6um bit-line pitch by 3.0um double word line pitch, with a cell size of about 4.8um² obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell.

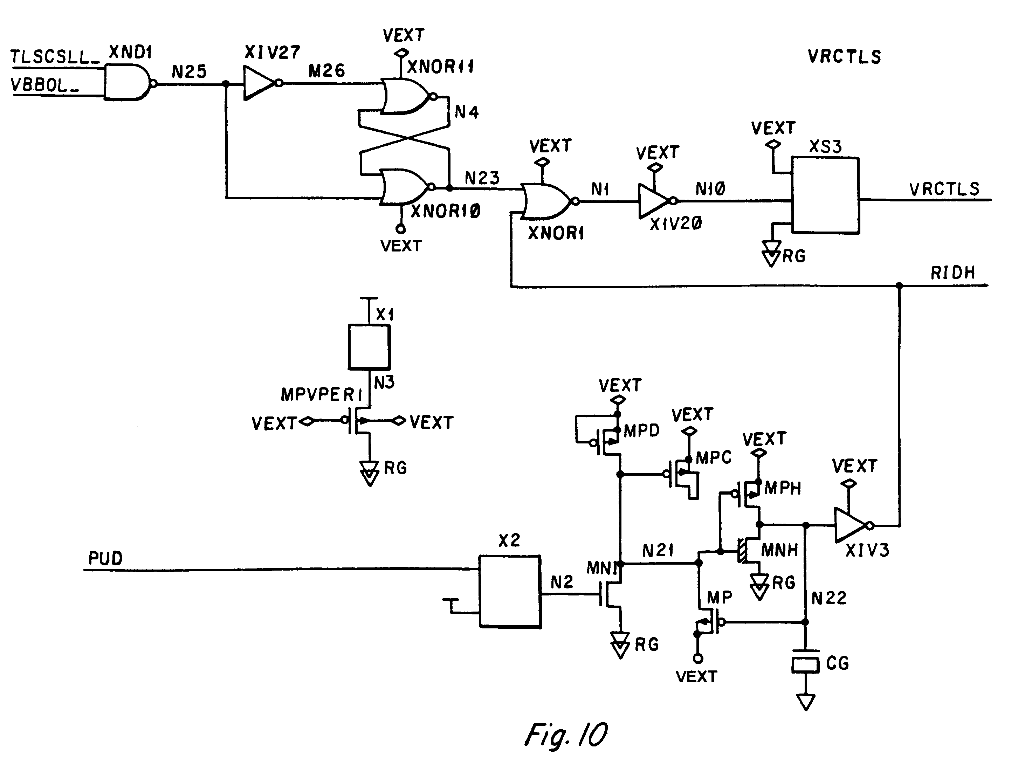

In the circuit of FIG. 10, P-channel transistor MP coupled Node N21 to external VDD. The gate of transistor MP is connected to Node N22. Node N22 is connected to one terminal of capacitor CG. The other terminal of capacitor CG is connected to VSS. P-channel transistor MPH and low threshold voltage N-channel transistor MNH are connected in series and biased respectively between VDD and VSSRG. Their gates are connected to Node N21. Their series connection is connected to Node N22. Node N22 is connected to the input of the inverter XIV3. Inverter XIV3 is biased by VDD. The output of Node XIV3 is connected to RIDH.

In the circuit, VRCTLS of FIG. 10, signals TLSCSLL_ and VBBOL_ are connected to NAND gate XND1. The output of NAND gate XND1 is connected to an input of NOR gate XNOR10 and is coupled through inverter XIV27 to the first input of NOR gate XNOR11. The output of NOR gate XNOR10 is connected to the input of NOR gate XNOR11 mand the output of NOR gate XNOR11 is connected to the first input of NOR gate XNOR10. NOR gates XNOR10 and XNOR11 are biased by VDD. The output of NOR gate XNOR10 is connected to the first input of NOR gate XNOR1. The other input of NOR gate NOR1 is the signal RIDH. The output of NOR gate XNOR1 is coupled through inverter XIV28 to the B terminal of the SEITCH XS3. Both NOR gate XNOR1 and inverter XIV28 are biased by VDD. The A terminal of SWITCH XS3 is connected to VDD. The C terminal of SWITCH XS3 is connected to VSSRG. The common terminal of SWITCH XS3 is connected to VRCTLS. P-channel transistor MPVPERI has its gate connected to VDD, the transistor is coupled between node N3 and voltage VSSRG. The substrate is connected to VDD. Switch X1 connects node N3 to voltage VPERI.
- VRCTLS: - VOLTAGE REGULATOR CONTROL LOGIC for STANDBY
- schematic FIG. 10

VRCLTS is the signal that controls the operation of both standby drivers. The standby drivers are active all the time except for DFT, Storage Cell stress operation and during latchup, i.e., when VBB goes to OV>

At powerup, node N22 of capacitor CG remains low while node N21 with capacitor MPC tracks the external voltage. Thus, RIDH is set to logic '1' and it tracks the external voltage even after N21 goes high and N22 goes low, with CG being charged up. As RIDH tracks the external voltage, it enables the standby drivers with active VRCTLS. This logic '1' RIDH signal also disables the output of 'Vbb ZERO LEVEL DETECTOR' to be used as latchup signal, during power up, while the VBB level is still at zero volts.

But, as the external voltage reaches about 2V, PUD goes to logic '1' thus returning RIDH to logic '0'. This passes the control of BRCTLS to the status of TLSCSLL_ and VBBOL). These are status of DFT, Storage Cell Stress test and latchup. Normally, VRCTLS stays active unless either TLSCSLL_ or VBBOL) is active. Besides, with RIDH at logic '0', it allows the output of VBB ZERO LEVEL DETECTOR to be the indicator of latchup.

The circuit consists of a pull-down N-channel transistor MNI, a low threshold voltage (Vt) N-channel pull down transistor MNH, two P-channel pull up transistors MP and MPH. Also included, are a coupling capacitor MPC to positive supply, and a coupling capacitor to ground, CG. A reverse biased leakage diode MPD is also included. Finally, an inverter, XIV3, is used to buffer the circuit from external loading that may disturb the balance of the circuit. The input to the circuit is the internally regulated voltage and is connected to the gate of transistor MN1.

For the very first ramp-up, both nodes N21 and N22 start from ground. During a fast ramp-up, capacitor coupling from MPC increases node voltage at N21 and turns on transistor MNH at very low voltage, resulting in a decreased node voltage at N22. With additional help from transistor MP, node N21 increases even faster and results in a steady initial state where N21 is high and N22 is low. During a slow ramp-up, however, it relies on the relative strength of transistors Mp and MPH. Since MP is chosen to be much larger than MPH, transistor MP has more capability to increase node voltage at N21 than transistor MPH does to node N22. Since MNH has relatively low threshold voltage, it helps to decrease node voltage N22 whenever node N21 gets up to a small voltage and therefore, speeds up the process of decreasing node N22. In the meantime, capacitor CG prevents transistor MPH from charging node N22 up too fast. Therefore, a correct initial state is ensured.

Once the circuit starts with the state that node N21 has higher voltage level than node N22 does, whenever the internal voltage connected to the gate of N-channel transistor MN1 goes up and turn on MN1, node N21 starts to decrease and reverses the state of node N22 . Therefore, the positive power up pulse, which is the final output pulse appearing at the output of inverter XIV3, is reset by a sufficient internal sizes of MP and MNI. Once the nodes are reversed, since there is no DC path to voltage supply there is no DC standby current. The circuit resets only after external voltage ramps down to ground.

During power down phase, transistor MPH conducts and discharges node N22 through the moat-to-tank diode. When node N22 discharges, transistor MP turns on to charge node N21 and therefore turns on transistor MNH and decreases node N22 further.

The circuit has been simulated to function at ramp-up rates ranging from tens of non-seconds to tens of seconds at various substrate potentials. The trip level of the circuit is approximately forty percent of external supply voltage.

## Claims

1. An integrated circuit to generate a power up reset pulse for a semiconductor device comprising
an on chip voltage generator that receives an external voltage and produces an internal voltage
a CMOS inverter (MNH, MPH) biased between said external voltage (V_{EXT}) ground, having its input (N21) coupled by an n-channel pull down transistor (MNI) to ground; and a p-channel pull up transistor (MP) biased by the external voltage, connected to the input (N21) of the CMOS inverter (MNH, MPH), and having its gate connected to the output (N22) of the CMOS inverter (MNH, MPH),
characterized in that
the gate of the pull down transistor (MNI) is connected to said internal voltage.

2. The circuit of claim 1 further comprising a capacitive means (MPC) for coupling the input of the CMOS inverter (MNH, MPH) to the external voltage.

3. The circuit of claim 2 wherein the capacitive means (MPC) is a P-channel transistor having its gate connected to the input of the CMOS inverter (MNH, MPH) and its source and drain connected to the external voltage.

4. The circuit of claim 2 further comprising a capacitor (CG) having one terminal connected to the output of the CMOS inverter (MNH, MPH) and the other terminal connected to ground.

5. A circuit as claimed in any preceding claim and further comprising reverse bias leakage diode coupling means (MPD) for coupling the input of the CMOS inverter (MNH, MPH) to the external voltage.

6. The circuit of claim 5 wherein the reverse bias leakage diode coupling means (MPD) is a P-channel transistor having its drain connected to the input of the CMOS inverter (MNH, MPH), and having its gate, source, and substrate connected to the external voltage.

7. A circuit as claimed in any preceding claim and further comprising a buffer (XIV3) biased by the external voltage having its input connected to the output of the CMOS inverter (MNH, MPH).

8. A circuit as claimed in claim 1 wherein the N-channel-transistor (MNH) of the CMOS inverter (MNH, MPH) has a low threshold voltage and the trip point of the CMOS inverter (MNH, MPH) is determined by the relative sizes of the pull down transistor (MNI) and the pull up transistor (MP).

9. A circuit as claimed in claim 5 wherein the pull up transistor (MP) is controlled by the output of the CMOS inverter (MNH, MPH) to couple the external voltage to the input of the CMOS inverter (MNH, MPH) during slow power ramp up ; and the capacative means (MPC) couples the external voltage to the input of the CMOS inverter (MNH, MPH) during fast power ramp up.

10. A ciruit as claimed in claim 9 wherein the reverse biased leakage diode coupling means (MPD) couples the external voltage to the input of the CMOS inverter (MNH, MPH) during slow power ramp up.

11. A memory device integrated onto a single semiconductor substrate, comprising:
an array of memory cells;
circuitry for writing and reading information into and from the memory cells;
a voltage generator that receives external voltage and produces internal voltage to power the array and the circuitry for writing and reading; and
a circuit as claimed in any preceding claim to detect power up.

## Patentansprüche

1. Integrierte Schaltung für die Erzeugung eines Einschaltrücksetzimpulses für eine Halbleitervorrichtung, mit
einem auf dem Chip befindlichen Spannungsgenerator, der eine externe Spannung empfängt und eine interne Spannung erzeugt,
einem CMOS-Inverter (MNH, MPH), der zwischen die externe Spannung (V_{EXT}) und Masse geschaltet ist und dessen Eingang (N21) über einen n-Kanal-Pulldown-Transistor (MNI) mit Masse gekoppelt ist; und einem p-Kanal-Pullup-Tran-sistor (MP), der durch die externe Spannung vorgespannt ist, an den Eingang (N21) des CMOS-Inverters (MNH, MPH) angeschlossen ist und mit seinem Gate an den Ausgang (N22) des CMOS-Inverters (MNH, MPH) angeschlossen ist,
dadurch gekennzeichnet, daß das Gate des Pulldown-Tran-sistors (MNI) an die interne Spannung angeschlossen ist.

2. Schaltung nach Anspruch 1, ferner mit einer kapazitiven Einrichtung (MPC) zum Koppeln des Eingangs des CMOS-Inverters (MNH, MPH) an die externe Spannung.

3. Schaltung nach Anspruch 2, bei der die kapazitive Einrichtung (MPC) ein P-Kanal-Transistor ist, dessen Gate an den Eingang des CMOS-Inverters (MNH, MPH) angeschlossen ist und dessen Source und dessen Drain an die externe Spannung angeschlossen sind.

4. Schaltung nach Anspruch 2, ferner mit einem Kondensator (CG), wovon ein Anschluß an den Ausgang des CMOS-Inverters (MNH, MPH) angeschlossen ist und der andere Anschluß an Masse angeschlossen ist.

5. Schaltung nach irgendeinem vorangehenden Anspruch, ferner mit einer Sperrspannungsableitungsdioden-Kopplungseinrichtung (MPD), die den Eingang des CMOS-Inverters (MNH, MPH) an die externe Spannung koppelt.

6. Schaltung nach Anspruch 5, bei der die Sperrspannungsableitungsdioden-Kopplungseinrichtung (MPD) ein P-Kanal-Transistor ist, dessen Drain an den Eingang des CMOS-Inverters (MNH, MPH) angeschlossen ist und dessen Gate, dessen Source und dessen Substrat an die externe Spannung angeschlossen sind.

7. Schaltung nach irgendeinem vorangehenden Anspruch, ferner mit einem Puffer (XIV3), der durch die externe Spannung vorgespannt ist und dessen Eingang an den Ausgang des CMOS-Inverters (MNH, MPH) angeschlossen ist.

8. Schaltung nach Anspruch 1, bei der der N-Kanal-Transistor (MNH) des CMOS-Inverters (MNH, MPH) eine niedrige Schwellenspannung besitzt und der Auslösepunkt des CMOS-Inverters (MNH, MPH) durch die relativen Größen des PulldownTransistors (MNI) und des Pullup-Transistors (MP) bestimmt ist.

9. Schaltung nach Anspruch 5, bei der der Pullup-Transistor (MP) durch den Ausgang des CMOS-Inverters (MNH, MPH) gesteuert wird, um die externe Spannung während einer langsamen Einschaltrampe an den Eingang des CMOS-Inverters (MNH, MPH) anzulegen; und die kapazitive Einrichtung (MPC) die externe Spannung während einer schnellen Einschaltrampe an den Eingang des CMOS-Inverters (MNH, MPH) anlegt.

10. Schaltung nach Anspruch 9, bei der die Sperrspannungsableitungsdioden-Kopplungseinrichtung (MPD) die externe Spannung während einer langsamen Einschaltrampe an den Eingang des CMOS-Inverters (MNH, MPH) anlegt.

11. Speichervorrichtung, die auf einem einzigen Halbleitersubstrat integriert ist, mit:
einer Matrix von Speicherzellen;
einer Schaltungsanordnung zum Schreiben und Lesen von Informationen in die Speicherzellen bzw. aus den Speicherzellen;
einem Spannungsgenerator, der eine externe Spannung empfängt und eine interne Spannung erzeugt, um die Matrix und die Schaltungsanordnung zum Schreiben und Lesen mit Leistung zu versorgen; und
einer Schaltung nach irgendeinem der vorangehenden Ansprüche, die das Einschalten erfaßt.

## Revendications

1. Circuit intégré destiné à produire une impulsion de remise à l'état initial d'accroissement de puissance pour un dispositif à semiconducteurs, comprenant un générateur de tension sur puce, qui reçoit une tension externe et produit une tension interne,
un inverseur CMOS (MNH, MPH) polarisé entre ladite tension externe (Vext) et la masse, dont l'entrée (N21) est couplée par un transistor abaisseur canal n (MNI) à la masse ; et un transistor élévateur à canal p (MP) polarisé par la tension extérieure et qui est connecté à l'entrée (N21) de l'inverseur CMOS (MNH, MPH) et dont la grille est connectée à la sortie (N22) de l'inverseur CMOS (MNH, MPH), caractérisé en ce que la grille du transistor abaisseur (MNI) est connectée à ladite tension interne.

2. Circuit selon la revendication 1, comprenant en outre des moyens capacitifs (MPC) pour coupler l'entrée de l'inverseur CMOS (MNH, MPH) à la tension externe.

3. Circuit selon la revendication 2, dans lequel les moyens capacitifs (MPC) sont un transistor à canal P, dont la grille est connectée à l'entrée de l'inverseur CMOS (MNH, MPH) et dont la source et le drain sont connectés à la tension externe.

4. Circuit selon la revendication 2, comprenant en outre un condensateur (CG) comportant une borne connectée à la sortie de l'inverseur CMOS (MNH, MPH) et dont l'autre borne est connectée à la masse.

5. Circuit selon l'une quelconque des revendications précédentes, comprenant en outre des moyens de couplage à diode de fuite à polarisation inverse (MPD) servant à coupler l'entrée de l'inverseur CMOS (MNH, MPH) à la tension externe.

6. Circuit selon la revendication 5, dans lequel les moyens de couplage à diode de fuite à polarisation inverse (MPD) sont un transistor à canal P dont le drain est connecté à l'entrée de l'inverseur CMOS (MNH, MPH) et dont la grille, la source et le substrat sont connectés à la tension externe.

7. Circuit selon l'une quelconque des revendications précédentes et comprenant en outre un tampon (XIV3) polarisé par la tension externe et dont l'entrée est connectée à la sortie de l'inverseur CMOS (MNH, MPH).

8. Circuit selon la revendication 1, dans lequel le transistor à canal N (MNH) de l'inverseur CMOS (MNH, MPH) possède une faible tension de seuil, et le point de déclenchement de l'inverseur CMOS (MNH, MPH) est déterminé par les dimensions relatives du transistor abaisseur (MNI) et du transistor élévateur (MP).

9. Circuit selon la revendication 5, dans lequel le transistor élévateur (MP) est commandé par la sortie de l'inverseur CMOS (MNH, MPH) pour coupler la tension externe à l'entrée de l'inverseur CMOS (MNH, MPH) pendant une montée lente en rampe de la puissance ; et les moyens capacitifs (MPC) couplent la tension externe à l'entrée de l'inverseur CMOS (MNH, MPH) pendant une montée rapide en rampe de la puissance.

10. Circuit selon la revendication 9, dans lequel les moyens de couplage à diode de fuite à polarisation inverse (MPD) accouplent la tension externe à l'entrée de l'inverseur CMOS (MNH, MPH) pendant une montée lente en rampe de la puissance.

11. Dispositif de mémoire intégré dans un seul substrat semiconducteur, comprenant :
un réseau de cellules de mémoire ;
un circuit pour écrire et lire une information dans et à partir des cellules de mémoire ;
un générateur de tension qui reçoit une tension externe et produit une tension interne pour alimenter le réseau et le circuit pour l'écriture et la lecture ; et
un circuit tel que revendiqué dans l'une quelconque des revendications précédentes pour détecter un accroissement de puissance.
